# EUROPEAN PATENT APPLICATION

(11) **EP 1 443 550 A1**
(43) Date of publication of application: **04.08.2004**
(21) Application number: 03290231.4
(22) Date of filing: 29.01.2003
(51) Int. Cl.: H01L 21/762, H01L 21/20

(54) **A method for fabricating a strained crystalline layer on an insulator, a semiconductor structure therefor, and a fabricated semiconductor structure**

(71) Applicant: S.O.I. Tec Silicon on Insulator Technologies S.A., 38190 Bernin (FR)
(72) Inventor: Aulnette, Cécile, 38000 Grenoble (FR); Mazuré, Carlos, 38330 St Nazaire les Eymes (FR)
(74) Representative: Grünecker, Kinkeldey, Stockmair & Schwanhäusser Anwaltssozietät

(57) **Abstract**

The present invention relates to a method for fabricating a strained crystalline layer on an insulator, to a semiconductor structure for fabricating a strained crystalline layer on an insulator, and to a semiconductor structure which is fabricated therewith. It is the object of the present invention to provide a semiconductor structure and an easy method for fabricating a semiconductor structure having a high crystal quality and having a high strained crystal semiconductor layer on top of an insulator. The object is solved by a method and a semiconductor structure for fabricating a strained crystalline layer on an insulator, the method comprising: providing a semiconductor donor substrate comprising germanium and/or an A(III)-B(V)-semiconductor, providing at least one first crystalline epitaxial layer, in a first step, wherein the content of germanium and/or the A(III)-B(V)-semiconductor of a buffer layer of the first layer is decreased during the first step; providing at least one insulator layer, in a second step; wherein the first layer is provided between the substrate and the insulator layer; splitting of the first layer, in a third step; and providing at least one second crystalline epitaxial layer on the split first layer, in a fourth step. The object of the invention is further solved by a method and a semiconductor structure for fabricating a strained crystalline layer on an insulator, the method comprising: providing a semiconductor donor substrate comprising germanium and/or an A(III)-B(V)-semiconductor; providing at least one first crystalline epitaxial layer, in a first step, wherein the content of germanium and/or the A(III)-B(V)-semiconductor of the first layer is decreased during the first step; wherein the first layer is provided between the donor substrate and the second layer; providing at least one second crystalline epitaxial layer, in a second step; providing at least one insulator layer, in a third step, wherein the second layer is provided between the first layer and the insulator layer; and splitting the structure between the first layer and the second layer, in a fourth step.

## Description

The present invention relates to a method for fabricating a strained crystalline layer on an insulator, to a semiconductor structure for fabricating a strained crystalline layer on an insulator, and to a semiconductor structure which is fabricated therewith.

Strained, thin semiconductor layers such as silicon layers have advantageous electron and hole mobility characteristics. Therefore, such layers are very interesting in nearly all parts of microelectronics because their use can lead to high performance devices with a high speed and low power consumption. Strained semiconductor layers can yet more effectively be used if they are transferred on an insulator layer resulting in a SOI (silicon-on-insulator)-like structure, which benefits are commonly known in microelectronics and micromechanics.

Cheng et al published on 2001 IEEE International SOI Conference in their article "SiGe-on-Insulator (SGOI): Substrate Preparation and MOSFET Fabrication for Electron Mobility Evaluation", a method of fabricating an SiGe-on-insulator structure. In this method, a graded SiGe layer was grown on a single crystalline silicon donor wafer. During SiGe growth, the germanium content of the SiGe was gradually increased until a germanium percentage of about 25% was reached. At this percentage, a relaxed SiGe layer was grown on the graded SiGe layer. Further, hydrogen ions were implanted into the relaxed SiGe layer, forming a pre-weakened level in the relaxed SiGe layer. Thereafter, the implanted structure was bonded with an oxidised silicon wafer. After an annealing, the bonded structure was split into two parts along the pre-weakened level resulting in the SiGe-on-insulator structure and a residual structure. Then, a strained silicon layer was grown on the SiGe layer resulting in a Si-on-SiGe-on-insulator structure.

The structure of the method described above has the disadvantage that the strain of the strained silicon layer on top of the SiGe layer cannot be increased to a value of commercial importance. This is due to the limited germanium content of the SiGe layer which cannot be increased over 25% without the risk of a formation of a high dislocation density in the SiGe layer which influences considerably the electronic characteristics of the strained silicon layer.

It is the object of the present invention to provide a semiconductor structure and an easy method for fabricating a semiconductor structure having a high crystal quality and having a high strained crystal semiconductor layer on top of an insulator.

The object is solved by a method for fabricating a strained crystalline layer on an insulator, comprising: providing a semiconductor donor substrate comprising germanium and/or an A(III)-B(V)-semiconductor; providing at least one first crystalline epitaxial layer in a first step, wherein the content of germanium and/or the A(III)-B(V)-semiconductor of a buffer layer of the first layer is proportionately decreased during the first step; providing at least one insulator layer in a second step, wherein the first layer is provided between the substrate and the insulator layer; splitting of the first layer, in a third step; and providing at least one second crystalline epitaxial layer on the split first layer, in a fourth step.

By the inventive method it is possible to fabricate a semiconductor structure in which the germanium and/or A(III)-B(V)-semiconductor content decreases in a direction from the substrate to a second layer. This way a very high content of germanium and/or the A(III)-B(V)-semiconductor can be achieved in the first layer resulting in a high strain of the second layer. The increase of germanium and/or the A(III)-B(V)-semiconductor allows growing of at least a part of the first layer with a low defect density, which results in a high crystal quality of the second layer. The high strained and high quality second layer can easily be transferred with the inventive method to an insulator layer resulting in a semiconductor structure which combines the benefits of a SOI-structure with the very good electronic characteristics of a strained crystalline layer.

According to a further embodiment of the invention, the first layer is provided on a single crystal germanium wafer, a single crystal A(III)-B(V)-semiconductor wafer, an epitaxial germanium layer or an epitaxial A(III)-B(V)-semiconductor layer, in the first step. On these substrates, the first layer can be grown with a high germanium content and a high crystal quality. The germanium wafer and/or the A(III)-B(V)-semiconductor wafer is a stable substrate which allows good handling of a strained crystalline layer on the insulator in the fabrication process.

In an advantageous embodiment of the invention, the germanium and/or the A(III)-B(V)-semiconductor content of the buffer layer is decreased in the first step to a proportion of about 40% to 80% germanium, preferably about 50% to 80% or about 60% to 80%. This high amount of germanium and/or A(III)-B(V)-semiconductor can result in a high strain of the second layer.

In a favourable embodiment of the invention, a silicon content of the buffer layer is increased in the first step to a proportion of 30% to 60% silicon, preferably to about 20% to 50% or 20% to 40%. The proportionate increase of silicon allows a good relaxation of the buffer layer, especially of a GeSi layer, in the first step.

In another preferable embodiment of the invention, the second layer is grown up to a thickness below 50 nm. This layer thickness is below a critical thickness so that thermodynamic instability of the layer can be prevented. In the inventive thin layer, a strain can be effectively built up.

The object is further solved by a semiconductor structure for fabricating a strained crystalline layer on an insulator, comprising: a semiconductor donor substrate of a first material comprising germanium and/or an A(III)-B(V)-semiconductor; at least one crystalline epitaxial layer; and at least one insulator layer on said, wherein the at least one crystalline epitaxial layer is an intermediate layer between the donor substrate and the insulator layer, and the at least one crystalline epitaxial layer comprises a buffer layer which is a composition comprising germanium and/or the A(III)-B(V)-semiconductor, the content of which decreases in a direction from the substrate to the insulator layer.

The inventive structure is an intermediate product for fabricating the strained crystalline layer on the insulator layer. Due to the decrease of germanium and/or the A(III)-B(V)-semiconductor in the crystalline epitaxial layer, beginning from the substrate, the crystalline epitaxial layer can be grown with a low defect density but with a high germanium and/or A(III)-B(V)-semiconductor content which is a basis for a good growth of a high strained and high quality further crystalline layer, for instance on the crystalline epitaxial layer of the inventive structure.

In a favourable variant of the invention, the donor substrate is a single crystal germanium wafer, a single crystal A(III)-B(V)-semiconductor wafer, an epitaxial germanium layer or an epitaxial A(III)-B(V)-semiconductor layer. The wafers as well as the epitaxial layer contain a high amount of germanium and/or the A(III)-B(V)-semiconductor which allows a good growth of a high content germanium and/or A(III)-B(V)-semiconductor crystalline epitaxial layer on the substrates wherein the crystalline epitaxial layer has a low defect density.

In a favourable example of the invention, the germanium and/or A(III)-B(V)-semiconductor content of the crystalline epitaxial layer decreases to a proportion of about 40% to 80%, preferably about 50% to 80% or about 60% to 80%. The percentage of about 40% to 80% germanium and/or A(II I)-B(V)-semiconductor allows a good growth of a strained crystalline layer on top of the crystalline epitaxial layer, whereas the percentage of about 50% to 80% is more advantageous to get higher strains in a top crystalline layer and the region of about 60% and 80% germanium is the most favourable region to produce a very high strain in a crystalline layer on top of the crystalline epitaxial layer.

According to an advantageous example of the invention, a silicon content of the crystalline epitaxial layer increases in a direction from the substrate to the insulator layer. The proportionate increase of silicon results in a good adaptation of the lattice which leads to a low defect density of the crystalline epitaxial layer.

In another preferable embodiment of the invention, the silicon content increases to a proportion of about 20% to 60% silicon, preferably about 20% to 50% or about 20% to 40%. The percentage of about 20% to 60% silicon makes it possible to get low defect density results of the crystalline epitaxial layer and a good adaptation of a top crystalline epitaxial layer such as a silicon layer, whereas the percentage of 20% to 50% silicon is more favourable for a high crystallinity of the crystalline epitaxial layer resulting in very good characteristic of a top crystalline layer such as a silicon layer, and the percentage of 20% to 40% silicon is the most favourable region to produce a high quality crystalline epitaxial layer which forms a very good basis for a strained crystalline layer of high quality on top of the crystalline epitaxial layer.

In yet another favourable example of the invention, the first layer and/or the second layer comprises carbon. Preferably, a carbon concentration of a few percent carbon, and even below 1% carbon, leads to an excellent dopant stability and a high strain level in the first layer and/or the second layer.

The object of the invention is additionally solved by a semiconductor structure comprising: a semiconductor base substrate; at least one insulator layer; and at least one first crystalline epitaxial layer; wherein the insulator layer is an intermediate layer between the base substrate and the first layer, and the first layer comprises a buffer layer which is a composition comprising germanium and/or an A(III)-B(V)-semiconductor, the content of which decreases in a direction from the insulator layer to the second layer.

Due to the decrease of germanium and/or the A(III)-B(V)-semiconductor in the buffer layer, at least a part of the first layer has a very low defect density which can result in a high quality of crystallinity of a further layer on top of the first layer.

In another preferable embodiment of the invention, the structure further comprises at least one strained second crystalline epitaxial layer, wherein the first layer is an intermediate layer between the insulator layer and the second layer. The inventive structure combines both the benefits of a SOI-structure and the good conductivity characteristics of a strained crystalline layer. The strained layer can have a very high strain because the germanium and/or the A(III)-B(V)-semiconductor content of the first layer can be adjusted at a very high content.

In a further favourable variant of the invention, the germanium and/or the A(III)-B(V)-semiconductor content of the buffer layer decreases to a proportion of about 40% to 80% germanium, preferably about 50% to 80% or about 60% to 80%. The content of 40% to 80% germanium and/or A(III)-B(V)-semiconductor is relatively high which can result in a high strain of a crystalline epitaxial layer such as a silicon layer on top of the first layer, whereas the percentage of 50% to 80% is more favourable to achieve higher strain results in a top crystalline epitaxial layer on the first layer, and the percentage of 60% to 80% is the most favourable region to produce very high strain results of a crystalline epitaxial layer such as a silicon layer on top of the first layer.

In another embodiment of the invention, a silicon content of the buffer layer increases in a direction from the insulator layer to the second layer. The increase of silicon results in a good adaptation of the lattice of the buffer layer in the direction of the second layer resulting in a high quality crystallinity of at least a part of the first layer which is a good basis for a high quality of crystallinity of the second layer.

In yet another preferable example of the invention, the silicon content increases to a proportion of about 20% to 60% silicon, preferably about 20% to 50% or about 20% to 40%. The amount of about 20% to 60% silicon allows a good growth of a strained silicon layer on top of the first layer, whereas the percentage of 20% to 50% is more favourable to get a higher strained silicon layer on the first layer, and the percentage of 20% to 40% is the most favourable region to get high strained silicon layer on top of the first layer.

In a further advantageous example of the invention, the strained layer has a thickness below 50 nm. This layer thickness results in a good thermodynamic stability of the second layer so that in this thin layer a strain can easily build up.

In a yet further advantageous embodiment of the invention, the first layer and/or the second layer comprises carbon. The carbon content makes it possible for the first layer and/or the second layer to be more stable and to show a better strain level.

The object of the invention is further solved by a method for fabricating a strained crystalline layer on an insulator, comprising: providing a semiconductor donor substrate comprising germanium and/or an A(III)-B(V)-semiconductor; providing at least one first crystalline epitaxial layer in a first step, wherein the content of germanium and/or the A(III)-B(V)-semiconductor of a buffer layer of the first layer is decreased during the first step; providing at least one second crystalline epitaxial layer on the first layer, in a second step, wherein the first layer is provided between the donor substrate and the second layer; providing at least one insulator layer, in a third step, wherein the second layer is provided between the first layer and the insulator layer; and splitting the structure between the first layer and the second layer, in a fourth step.

Due to the decrease of the germanium and/or the A(III)-B(V)-semiconductor content of the buffer layer, at least a part of the first layer can be provided with a very good crystallinity and a low defect density resulting in a high quality of the second crystalline layer which can be provided on top of the first layer. Starting with germanium and/or an A(III)-B(V)-semiconductor as the semiconductor donor substrate, the germanium and/or the A(III)-B(V)-semiconductor content of the buffer layer can be decreased to a relatively high amount of germanium and/or A(III)-B(V)-semiconductor resulting in a high strain of the second crystalline layer, such as a silicon layer, on top of the first layer. The inventive method has further the advantage that the good electronic characteristics of a strained second layer can be combined with the benefits of a SOI layer because the second strained layer can be provided on the insulator layer. The inventive method comprises a simple sequence of steps for an easy fabrication of the inventive semiconductor structure.

In a further embodiment of the invention, the first layer is provided on a single crystal germanium wafer, a single crystal A(III)-B(V)-semiconductor wafer, an epitaxial germanium layer or an epitaxial A(III)-B(V)-semiconductor layer, in the first step. These substrates provide a high amount of germanium and/or the A(III)-B(V)-semiconductor such as GaAs resulting in a good growth of a high content germanium and/or A(III)-B(V)-semiconductor first layer on the respective substrate.

In an advantageous example of the invention, the second layer is grown up to a thickness below the 50 nm. At this thickness, the second layer is thermodynamically stable and the second layer can be grown with a high strain.

According to another preferable embodiment of the invention, the germanium and/or A(III)-B(V)-semiconductor content of the buffer layer is decreased in the first step to a proportion of about 40% to 80% germanium, preferably about 50% to 80% or about 60% to 80%. The percentage of 40% to 80% germanium and/or A(III)-B(V)-semiconductor of the buffer layer forms a good basis for a high strained second layer, whereas the percentage of 50% to 80% germanium of the first layer is more favourable to get a higher strain in the second layer and the percentage of about 60% to 80% germanium is the most favourable region to achieve a very high strain in the second layer.

In yet another advantageous embodiment of the invention, a silicon content of the buffer layer is increased in the first step to a proportion of about 20% to 60% silicon, preferably to about 20% to 50% or about 20% to 40%. At the percentage of about 20% to 60% silicon a high strained silicon layer can be grown on top of the first layer, whereas the percentage of 20% to 50% silicon is more favourable to achieve a high strain result in the second layer such as a silicon layer on top of the first layer and the percentage of about 20% to 40% silicon is the most favourable region to get very high strain results in the second layer such as a silicon layer.

The object is in addition solved by a semiconductor structure for fabricating a strained crystalline layer on an insulator, comprising: a semiconductor donor substrate of a first material comprising germanium and/or an A(III)-B(V)-semiconductor; at least one first crystalline epitaxial layer; at least one second crystalline epitaxial layer; and at least one insulator layer, wherein the first layer is an intermediate layer between the donor substrate and the second layer, the second layer is an intermediate layer between the first layer and the insulator layer, and the first layer comprises a buffer layer which is a composition comprising germanium and/or the A(III)-B(V)-semiconductor, the content of which decreases in a direction from the substrate to the second layer.

The inventive structure is an intermediate structure for fabricating a strained crystalline layer on the insulator layer. Due to the decrease of the germanium and/or the A(III)-B(V)-semiconductor content in the buffer layer from the substrate to the second layer, the germanium and/or A(III)-B(V)-semiconductor content of the buffer layer can be decreased to a relatively high amount of germanium and/or the A(III)-B(V)-semiconductor resulting in a high strain of the second layer which can be brought on top of the first layer. The proportionate decrease of the germanium and/or the A(III)-B(V)-semiconductor further results in a low defect density of at least a part of the first layer leading to a high quality of the second layer. The inventive structure further has the advantage that the second strained layer can be brought on the insulator layer so that an SOI-structure can easily be formed starting from the inventive structure.

In a further favourable embodiment of the invention, the donor substrate is a single crystal germanium wafer, a single crystal A(III)-B(V)-semiconductor wafer, an epitaxial germanium layer or an epitaxial A(III)-B(V)-semiconductor layer. These substrates comprise a high amount of germanium and/or the A(III)-B(V)-semiconductor which is advantageous for a high quality growth of the germanium and/or A(III)-B(V)-semiconductor containing first layer.

In yet another advantageous embodiment of the invention, the germanium and/or the A(III)-B(V)-semiconductor content of the first layer decreases to a proportion of about 40% to 80%, preferably about 50% to 80% or about 60% to 80%. The percentage of 40% to 80% germanium and/or A(III)-B(V)-semiconductor allows growing of a high strained second layer on top of the first layer, whereas the percentage of about 50% to 80% is more favourable to get higher strain results in the second layer and the percentage of about 60% to 80% is the most favourable region to achieve very high strain results in the second layer on top of the first layer.

In another favourable example of the invention, a silicon content of the buffer layer increases in a direction from the substrate to the insulator layer. Said increase of silicon makes it possible that the lattice of the first layer can well adapt onto the substrate resulting in a low defect density of at least a part of the first layer.

In a further advantageous embodiment of the invention, the silicon content increases to a proportion of about 20% to 60% silicon, preferably about 20% to 50% or about 20% to 40%. The percentage of about 20% to 60% silicon allows a good growth of a high strained second layer such as a silicon layer, whereas the percentage of about 20% to 50% silicon is more favourable to get higher strain results of the second layer such as a silicon layer, and the percentage of about 20% to 40% silicon is the most favourable region to achieve very strain results in the second layer such as a silicon layer.

In yet another advantageous embodiment of the invention, the first layer and/or the second layer comprises carbon. Carbon, preferably of a low content such as below a few percent carbon, and even below 1% carbon, results in a high dopant stability and a good strain characteristic of the first layer and/or the second layer.

In the following, preferable embodiments of the invention are described with reference to the accompanying figures in which
Fig. 1 shows schematically a semiconductor substrate which is used in a first step of a method according to a first embodiment of the present invention;
Fig. 2 shows schematically the first step of the first embodiment of the present invention;
Fig. 3 shows schematically a second step of the first embodiment of the present invention resulting in a semiconductor structure according to a third embodiment of the present invention;
Fig. 4 shows schematically an implantation step applied on the structure shown in fig. 3;
Fig. 5 shows schematically a bonding step of the structure of fig. 4;
Fig. 6 shows schematically a splitting step of the structure of fig. 5 according to a third step of the first embodiment of the present invention;
Fig. 7 shows schematically an inventive semiconductor structure which has been fabricated by the method according to the first embodiment of the present invention which is shown in figs. 1 to 6;
Fig. 8 shows schematically a semiconductor substrate which is used in a first step of a second embodiment of the present invention;
Fig. 9 shows schematically the first step of the second embodiment of the present invention;
Fig. 10 shows schematically a second step of the second embodiment of the present invention;
Fig. 11 shows schematically a third step of the second embodiment of the present invention resulting in a semiconductor structure according to a fourth embodiment of the present invention;
Fig. 12 shows schematically an implantation step applied on the structure shown in fig. 11;
Fig. 13 shows schematically a bonding step applied on the structure shown in fig. 12;
Fig. 14 shows schematically a fourth step of the second embodiment of the present invention which is applied on the structure shown in fig. 13;
Fig. 15 shows schematically an inventive structure which has been fabricated by the method according to the second embodiment of the present invention which is shown schematically in figs. 8 to 14; and
Fig. 16 shows schematically the concentration distribution versus thickness of the semiconductor structure shown in figs. 2 and 9.

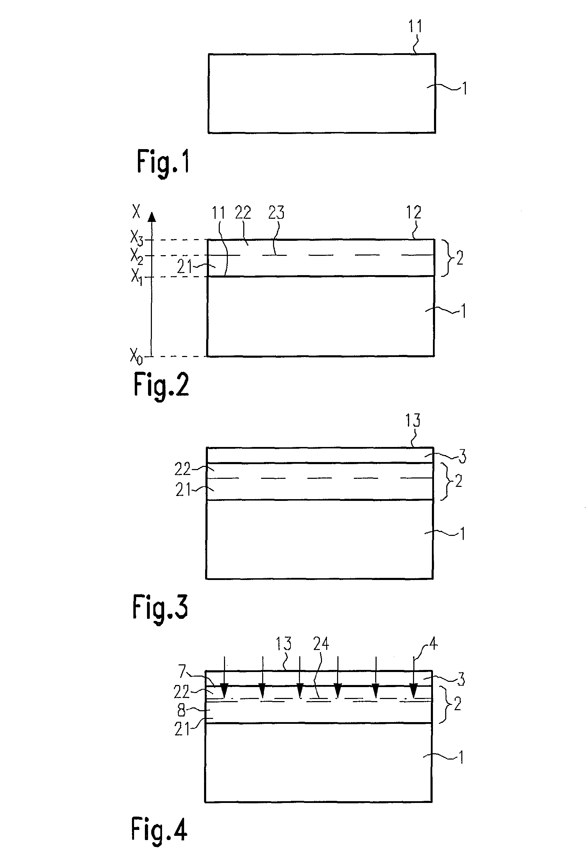

Fig. 1 shows schematically a semiconductor substrate 1 used in a first step of a method according to a first embodiment of the present invention. The semiconductor substrate 1 is a single crystal germanium wafer which has preferably a commonly available size and electronic characteristic. The germanium wafer or donor wafer 1 has a polished and cleaned upper surface 11.

In another embodiment of the present invention, the semiconductor donor substrate can be an A(III)-B(V)-semiconductor wafer such as a GaAs wafer, a substrate having on top an epitaxial Ge layer or an epitaxial A(III)-B(V)-semiconductor layer such as a GaAs layer. For instance, the substrate can contain a GaAs wafer or a GaAs layer which is covered by a Ge layer.

Fig. 2 shows schematically the first step of the first embodiment of the present invention. In the first step, a first crystalline epitaxial layer 2 is grown on the semiconductor donor substrate 1 shown in Fig. 1. The first crystalline epitaxial layer 2 consists of a composition of germanium and silicon forming a GeSi layer. The GeSi layer 2 is brought directly onto the upper surface 11 of the germanium wafer 1.

In yet another embodiment of the invention, a seed layer of Ge can be brought on the upper surface 11 prior to growing of the GeSi layer 2.

The GeSi layer 2 consists of two layers, a graded buffer GeSi layer 21 and a relaxed GeSi layer 22. The graded buffer GeSi layer 21 has near the surface 11 of the germanium wafer 1 a silicon concentration of about 0% whereas the silicon content of the buffer GeSi layer 21 increases gradually beginning from the surface 11 of the germanium wafer 1 up to a level 23 where the silicon content of the GeSi layer is about 20% to 60%. Correspondingly, the germanium content of the buffer GeSi layer 21 decreases beginning from about 100% at the surface 11 to a percentage of about 40% to 80% germanium at the level 23.

The GeSi layer 2 is doped with carbon the percentage of which is below 1%.

The relaxed GeSi layer is on top of the level 23 and has a silicon to germanium ratio which corresponds to about the maximum silicon to germanium ratio of the buffer layer 21. Especially the relaxed GeSi layer 22 has a very low defect density of about 10⁴ cm⁻².

Fig. 3 shows schematically a second step of the first embodiment of the present invention. In the second step, an insulator layer 3 is deposited on the first layer 2 so that the first layer 2 is an intermediate layer between the substrate 1 and the insulator layer 3. The insulator layer 3 consists of silicon dioxide and/or silicon nitride. In the embodiment shown, the insulator layer 3 is deposited at a temperature below 900°C. In another example of the invention, the insulator layer 3 can be a thermal oxide. The thickness of the insulator layer is adjusted to the target layer thickness of a SiGe/strained silicon layer which is to be transferred onto a base wafer. The insulator layer 3 has an upper surface 13.

The semiconductor structure shown in fig. 3 is an inventive structure according to a third embodiment of the present invention, which is an intermediate product for fabricating a strained crystalline layer on an insulator.

Fig. 4 shows an implantation step which is applied on the structure shown in Fig. 3. In the implantation step, the structure of Fig. 3 is implanted with hydrogen species 4 using an implantation dose of > 5 x 10¹⁶ cm⁻² at an appropriate energy below about 180 keV. The hydrogen species 4 go through the upper surface 13 and through the insulator layer 3 into the first layer 2 to a level 24 in the first layer 2. Preferably, the level 24 corresponds with the level 23 in the first layer 2, which is between the buffer GeSi layer 21 and the relaxed GeSi layer 22. Due to the implantation, the level 24 is pre-weakened and forms a predetermined splitting zone.

In a next step which is not shown in the figures, the surface 13 of the insulator layer 3 is cleaned with standard silicon IC manufacturing post-implantation treatments. If required, the insulator layer 3 may be removed and a fresh insulator layer can be deposited.

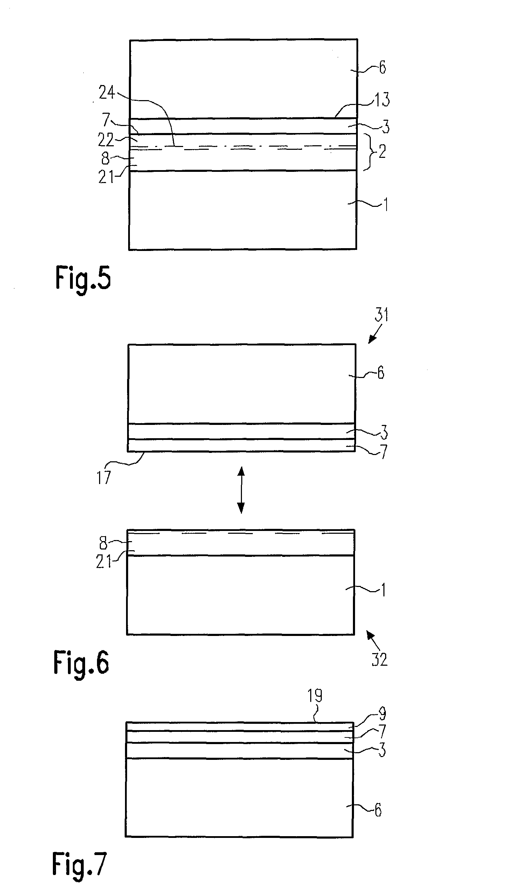

Fig. 5 shows a bonding step which is applied on the structure shown in Fig. 4. In the bonding step, a base wafer 6 consisting of silicon, germanium, an A(III)-B(V)-semiconductor, quartz, glass, etc. is surface treated and then bonded with the surface treated insulator layer 3 of the structure of fig. 4. Surface treatment before bonding can be made using chemical-mechanical polishing, surface scrubbing, oxygen-plasma treatment and other available surface treatment techniques. The base wafer 6 can directly be bonded on the surface 13 of the insulator layer 3. According to another embodiment of the invention, the base wafer 3 can have a dielectric layer on its bonding surface which will be bonded with the surface 13 of the insulator layer 3.

Fig. 6 shows a third step of the method according to the first embodiment of the present invention. The third step is a splitting step in which the structure shown in Fig. 5 is split into two semiconductor structure parts 31 and 32. The parts 31 and 32 are detached along the predetermined splitting line 24 which has been formed during the implantation step shown in Fig. 4. The resulting part 31 consists of the base wafer 6 on which the insulator layer 3 is formed, and on top of the part 31 is a part 7 of the GeSi layer 2. The part 7 consists preferably of a relaxed GeSi material.

The other part 32 which forms by the splitting step consists of a donor germanium wafer 1 on which the residual part 8 of the GeSi layer 2 is formed. The residual part 8 contains preferably the graded buffer GeSi layer 21 and residuals of the former relaxed GeSi layer 22.

In the splitting process shown in Fig. 6, essentially the parameters are used which are commonly used in this so-called Smart Cut® process which is described for instance in WO00/24059 which is herewith included by reference. For instance, splitting can occur by means of a thermal or a shock treatment of the structure shown in Fig. 5.

In a further step which is not shown, the part 7 of the GeSi layer 2 is finished by a chemical mechanical polishing and, optionally, by a thermal treatment.

Fig. 7 shows schematically a fourth step of the method according to the first embodiment of the present invention. In the fourth step, a second crystalline epitaxial layer is grown on the surface 17 of the split part 31. The second layer 9 is a strained silicon layer with a thickness below 50 nanometers and a carbon content below 1%. The strained silicon layer has a very high strain and a low defect density.

The semiconductor structure shown in Fig. 7 is an inventive structure which corresponds to an end product of the method according to the first embodiment of the present invention. The structure consists of the base wafer 6, the insulator layer 3, the part 7 of the GeSi layer 2 and the second layer 9, wherein the insulator layer 3 is an intermediate layer between the base wafer 6 and the part 7, and the part 7 is an intermediate layer between the insulator layer 3 and the second layer 9. In another embodiment of the invention, between each of the layers of the structure shown in Fig. 7, an additional layer such as a seed layer can be located.

The strain of the silicon layer 9 is the strain which results when a crystalline silicon layer of a thickness below 50 nm is grown epitaxially on a GeSi layer with a germanium content of about 40 to 80% germanium, which strain is higher than the strain of a prior art silicon layer with a thickness below 50 nm which is grown on a GeSi layer with a germanium content below 40%.

The structure shown in Fig. 7 can be thermally annealed after growing of the strained silicon layer 9.

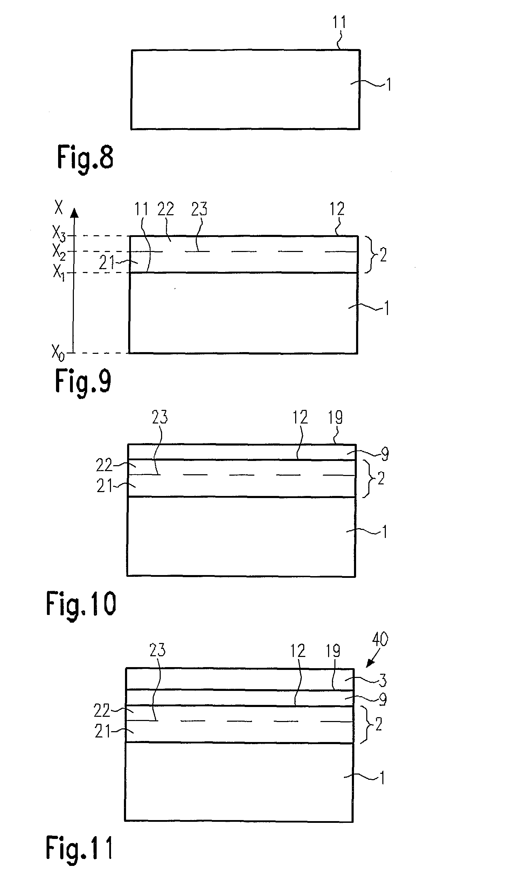

Fig. 8 to 13 show schematically steps of a method according to a second embodiment of the present invention. With reference to figs. 8 to 15, the same reference numerals which have been used with reference to figs. 1 to 7 are used to indicate the same parts and components as in figs. 1 to 7.

Fig. 8 shows schematically a semiconductor substrate 1 which is used in a first step of the second embodiment of the present invention. The semiconductor substrate 1 is a single crystal germanium wafer and has an upper surface 11.

Fig. 9 shows the first step of the second embodiment of the present invention. In the first step, a fourth crystalline epitaxial layer is grown on the upper surface 11 of a germanium wafer 1. As mentioned with reference to figs. 1 to 1, in another embodiment an A(III)-B(V)-semiconductor or a substrate having on top an epitaxial Ge or A(III)-B(V)-semiconductor layer can be used instead of the Ge wafer.

The first crystalline epitaxial layer 2 is a GeSi layer consisting of a graded buffer GeSi layer 21 and a relaxed GeSi 22. The graded buffer GeSi layer 21 is grown on the upper surface 11 of the germanium wafer 1 with a gradual increasing silicon content.

The silicon content increases beginning from the surface 11 at a percentage of about 0% to a level 23 in the first layer 2 at a percentage of about 20% to 60% silicon. Above the level 23, the relaxed GeSi 22 is grown with a nearly constant silicon to germanium ratio which corresponds approximately to the maximum silicon to germanium ratio of the graded buffer GeSi layer 21. Correspondingly, the germanium content of the graded buffer layer 21 decreases from the surface 11 where the germanium content is about 100% down to the level 23 where the germanium content is about 40% to 80% germanium. The GeSi layer 2 is doped with carbon at a percentage below 1 % carbon. The first layer 2 has an upper surface 12.

Fig. 10 shows schematically a second step of the method according to the second embodiment of the present invention. In the second step, a second crystalline epitaxial layer 9 with a carbon content below 1 % is grown on the first layer 2. The second crystalline epitaxial layer 9 is a strained silicon layer with a thickness below 50 nm. The strained silicon layer 9 has a very low crystal defect density and a high strain. The second layer has an upper surface 19.

Fig. 11 shows schematically a third step of the method according to the second embodiment of the present invention. In the third step, an insulator layer 3 is deposited on the surface 19 of the strained silicon layer 9. The insulator layer 3 consists of silicon dioxide and/or silicon nitride. The thickness of the insulator layer 3 depends on the target layer signals of the SiGe/strained silicon layer which has to be transferred on a base wafer. The insulator layer 3 has an upper surface 13.

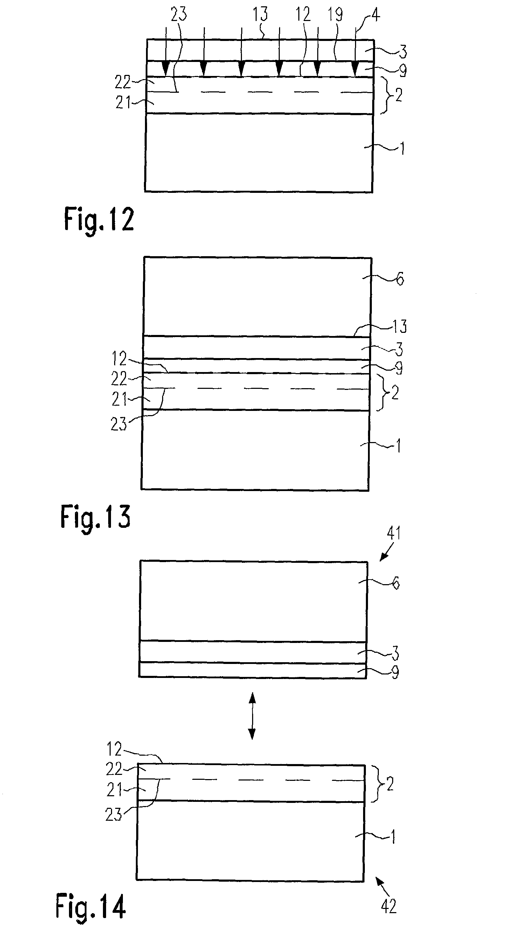

Fig. 12 shows an implantation step applied on the structure 40 shown in Fig. 11. In the implantation step, hydrogen species 4 are implanted through the upper surface 13 and through the insulator layer 3 until approximately the level of the former surface 12 which forms the interface between the GeSi layer 2 and the strained silicon layer 9. Due to the implantation, the interface 12 is pre-weakened resulting in a predetermined splitting zone at this interface 12.

The implantation is performed with a hydrogen dose of > 5 x 10¹⁴ cm⁻² at an appropriate energy below about 180 keV.

After implantation, the surface 13 is cleaned with standard silicon IC manufacturing post-implantation treatments. If required, the insulator layer 3 may be removed and a new fresh insulator layer can be deposited. These steps are not shown.

Then follows a surface treatment of the structure shown in Fig. 12 and in parallel of a base wafer consisting of silicon, germanium, an A(III)-B(V)-semiconductor, quartz, glass, etc. The surface treatment can be made with chemical-mechanical polishing, surface scrubbing, oxygen-plasma treatment or a similar process.

Fig. 13 shows a bonding step in which the structure shown in Fig. 12 is bonded with the base wafer 6. The base wafer 6 bonds on the surface 13 of the insulator layer 3. According to another embodiment of the present invention, the base wafer 6 can comprise at its bonding surface an insulator layer which is bonded with the surface 13 of the insulator layer 3.

Fig. 14 shows a fourth step of the method according to the second embodiment of the present invention. In the fourth step, the structure shown in Fig. 13 is split into two parts 41 and 42. The splitting step is performed similarly to the splitting of the Smart Cut® process in which a structure is split into two parts along a predetermined splitting line, for instance by a thermal or by a shock treatment.

In Fig. 14, the splitting line between parts 41 and 42 corresponds to the predetermined splitting zone at the interface 12 between the first layer 2 and the second strained silicon layer 9. The first split part 41 consists of the base wafer 6 on which the insulator layer 3 is formed and has on top the strained silicon layer 9 so that the insulator layer 3 is an intermediate layer between the base wafer 6 and the strained layer 9. In another embodiment of the invention, between the base wafer 6 and the insulator layer 3 and/or between the insulator layer 3 and the strained layer 9, an additional layer can be located. The split part 42 consists of the donor germanium wafer 1 on which the GeSi layer 2 is formed.

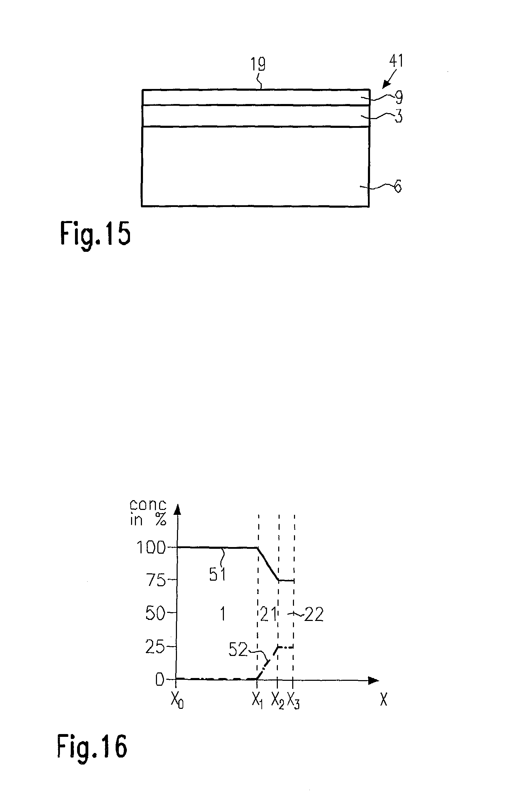

Fig. 15 shows schematically the end-product of the method according to the second embodiment of the present invention which corresponds to the split part 41 shown in Fig. 14. The structure 41 can be thermally annealed and GeSi residuals on the strained silicon layer 9 can be removed.

The strained silicon layer 9 of the structure 41 shown in Fig. 15 has a very high strain combined with very low defect density below 10⁴ cm⁻². The strain of the silicon layer 9 is the strain which results when a crystalline silicon layer of a thickness below 50 nm is grown epitaxially on a GeSi layer with a germanium content of about 40 to 70% germanium, which strain is higher than the strain of a prior art silicon layer with a thickness below 50 nm which is grown on a GeSi layer with a germanium content below 40%.

Fig. 16 shows schematically the concentration distribution versus thickness of the semiconductor structure shown in figs. 2 and 9. The reference numerals of fig. 16 which are identical to the reference numerals used with reference to figs. 2 and 9 indicate the same components as in figs. 2 and 9.

In fig. 16, the continuous line 51 represents the germanium content of the semiconductor structure shown in figs. 2 and 9, which is about 100% in the germanium substrate 1. The dashed line 52 represents the silicon content of the semiconductor structure of figs. 2 and 9 which is about 0% in the germanium substrate 1. The silicon content 52 increases in the graded buffer GeSi layer 21 from 0% to about 30%, whereas the germanium content 51 in the buffer layer 21 decreases to a value of about 70%. In fig. 16, the increase of silicon 52 and the decrease of germanium 51 is shown as being continuous. Instead of a continuous change, a gradual or a step-by-step change of the contents of silicon and/or germanium can be used in the buffer layer 21. Furthermore, there can be one or more regions in the buffer layer 21 in which there is no change of the germanium and/or the silicon content.

The relaxed GeSi layer 22 which is on top of the buffer layer 21 has a nearly constant proportion between germanium and silicon of about 30 to 60% silicon to about 40 to 70% germanium. The relaxed layer 22 is nearly dislocation-free. The crystal defect density of the relaxed layer 22 is below 10⁴ cm⁻².

Although the preferred embodiments described above use the Smart Cut® technology for layer transfer, any other layer transfer technique such as a Bond-and-Etchback technology or other fragilization technique using a porous layer formation can be applied.

## Claims

1. A method for fabricating a strained crystalline layer on an insulator, comprising:
providing a semiconductor donor substrate (1) comprising germanium and/or an A(III)-B(V)-semiconductor;
providing at least one first crystalline epitaxial layer (2), in a first step;
wherein the content of germanium and/or the A(III)-B(V)-semiconductor of a buffer layer (21) of the first layer (2) is decreased during the first step;
providing at least one insulator layer (3), in a second step;
wherein the first layer (2) is provided between the substrate (1) and the insulator layer (3);
splitting of the first layer (2), in a third step; and
providing at least one second crystalline epitaxial layer (9) on the split first layer (7), in a fourth step.

2. The method of claim 1,
**characterised in that**
the first layer (2) is provided on a single crystal germanium wafer (1), a single crystal A(III)-B(V)-semiconductor wafer, an epitaxial germanium layer or an epitaxial A(III)-B(V)-semiconductor layer, in the first step.

3. The method of at least one of the preceding claims,
**characterised in that**
the germanium and/or A(III)-B(V)-semiconductor content of the buffer layer (21) is decreased in the first step to a proportion of about 40 to 80%, preferably about 50 to 80% or about 60 to 80%.

4. The method of at least one of the preceding claims,
**characterised in that**
a silicon content of the buffer layer (2) is increased in the first step to a proportion of about 20 to 60% silicon, preferably about 20 to 50% or about 20 to 40%.

5. The method of at least one of the preceding claims,
**characterised in that**
the second layer (9) is grown up to a thickness below 50 nm.

6. A semiconductor structure for fabricating a strained crystalline layer on an insulator, comprising:
a semiconductor donor substrate (1) of a first material comprising germanium and/or an A(III)-B(V)-semiconductor;
at least one crystalline epitaxial layer (2); and
at least one insulator layer (3),
wherein the at least one crystalline epitaxial layer (2) is an intermediate layer between the donor substrate (1) and the insulator layer (3), and the at least one crystalline epitaxial layer (2) comprises a buffer layer (21) which is a composition comprising germanium and/or the A(III)-B(V)-semiconductor, the content of which decreases in a direction from the substrate (1) to the insulator layer (3).

7. The structure of claim 6,
**characterised in that**
the donor substrate is a single crystal germanium wafer (1), a single crystal A(III)-B(V)-semiconductor wafer, an epitaxial germanium layer or an epitaxial A(III)-B(V)-semiconductor layer.

8. The structure of at least one of the claims 6 or 7,
**characterised in that**
the germanium and/or the A(III)-B(V)-semiconductor content of the buffer layer (21) decreases to a proportion of about 40 to 80%, preferably about 50 to 80% or 60 to 80%.

9. The structure of at least one of the claims 6 to 8,
**characterised in that**
the silicon content of the first layer (2) increases in a direction from the substrate (1) to the insulator layer (3).

10. The structure of claim 9,
**characterised in that**
the silicon content increases to a proportion of about 20 to 60% silicon, preferably about 20 to 50% or about 20 to 40%.

11. The structure of at least one of the preceding claims,
**characterised in that**
the first layer (2) and/or the second layer (9) comprises carbon.

12. A semiconductor structure comprising:
a semiconductor base substrate (6);
at least one insulator layer (3); and
at least one first crystalline epitaxial layer (2);
wherein the insulator layer (3) is an intermediate layer between the base substrate (6) and the first layer (2), and the first layer (2) comprises a buffer layer (21) which is a composition comprising germanium and/or an A(III)-B(V)-semiconductor, the content of which decreases in a direction from the insulator layer (3) to the second layer (9).

13. The structure of claim 12,
**characterised in that**
the structure further comprises
at least one strained second crystalline epitaxial layer (9) wherein the first layer (2) is an intermediate layer between the insulator layer (3) and the second layer (9).

14. The structure of at least one of the claims 12 or 13,
**characterised in that**
the germanium and/or the A(III)-B(V)-semiconductor content of the buffer layer (2) decreases to a proportion of about 40 to 80%, preferably about 50 to 80% or about 60 to 80%.

15. The structure of at least one of the claims 12 or 14,
**characterised in that**
a silicon content of the buffer layer (2) increases in a direction from the insulator layer (3) to the second layer (9).

16. The structure of claim 15,
**characterised in that**
the silicon content increases to a proportion of about 20 to 60% silicon, preferably about 20 to 50% or about 20 to 40%.

17. The structure of at least one of the claims 12 to 16,
**characterised in that**
the strained second layer (9) has a thickness below 50 nm.

18. The structure of at least one of the claims 12 to 17
**characterised in that**
the first layer (2) and/or the second layer (9) comprises carbon.

19. A method for fabricating a strained crystalline layer on an insulator, comprising:
providing a semiconductor donor substrate (1) comprising germanium and/or an A(III)-B(V)-semiconductor;
providing at least one first crystalline epitaxial layer (2), in a first step;
wherein the content of germanium and/or the A(III)-B(V)-semiconductor of a buffer layer (21) of the first layer (2) is decreased during the first step;
providing at least one second crystalline epitaxial layer (9), in a second step;
wherein the first layer (2) is provided between the donor substrate (1) and the second layer (9);
providing at least one insulator layer (3), in a third step;
wherein the second layer (9) is provided between the first layer (2) and the insulator layer (3); and
splitting the structure between the first layer (2) and the second layer (9), in a fourth step.

20. The method of claim 19,
**characterised in that**
the first layer (2) is provided on a single crystal germanium wafer (1), a single crystal A(III)-B(V)-semiconductor wafer, an epitaxial germanium layer or an epitaxial A(III)-B(V)-semiconductor layer, in the first step.

21. The method of at least one of the claims 19 or 20,
**characterised in that**
the second layer (9) is grown up to a thickness below 50 nm.

22. The method of at least one of the claims 19 to 21,
**characterised in that**
the germanium and/or the A(III)-B(V)-semiconductor content of the buffer layer (21) is decreased in the first step to a proportion of about 40 to 80%, preferably about 50 to 80% or about 60 to 80%.

23. The method of at least one of the claims 19 to 22,
**characterised in that**
a silicon content of the buffer layer (21) is increased in the first step to a proportion of about 20 to 60% silicon, preferably about 20 to 50% or about 20 to 40%.

24. A semiconductor structure for fabricating a strained crystalline layer on an insulator, comprising:
a semiconductor donor substrate (1) of a first material comprising germanium and/or an A(III)-B(V)-semiconductor;
at least one first crystalline epitaxial layer (2);
at least one second crystalline epitaxial layer (9); and
at least one insulator layer (3);
wherein the first layer (2) is an intermediate layer between the donor substrate (1) and the second layer (9), the second layer (9) is an intermediate layer between the first layer (2) and the insulator layer (3), and the first layer (2) comprises a buffer layer (21) which is a composition comprising germanium and/or the A(III)-B(V)-semiconductor the content of which decreases in a direction from the substrate (1) to the second layer (9).

25. The structure of claim 24,
**characterised in that**
the donor substrate is a single crystal germanium wafer (1), a single crystal A(III)-B(V)-semiconductor wafer, an epitaxial germanium layer or an epitaxial A(III)-B(V)-semiconductor layer.

26. The structure of at least one of the claims 24 or 25,
**characterised in that**
the germanium and/or the A(III)-B(V)-semiconductor content of the buffer layer (21) decreases to a proportion of about 40 to 80% germanium, preferably about 50 to 80% or about 60 to 80%.

27. The structure of at least one of the claims 24 to 26,
**characterised in that**
a silicon content of the buffer layer (21) increases in a direction from the substrate (1) to the insulator layer (3).

28. The structure of claim 27,
**characterised in that**
the silicon content increases to a proportion of about 20 to 60% silicon, preferably about 20 to 50% or about 20 to 40%.

29. The structure of at least one of the claims 24 to 28,
**characterised in that**
the first layer (2) and/or the second layer (9) comprises carbon.
